# EUROPEAN PATENT APPLICATION

(11) **EP 4 435 873 A1**
(43) Date of publication of application: **25.09.2024**
(21) Application number: 22894190.2
(22) Date of filing: 23.05.2022
(51) Int. Cl.: H01L 31/068, H01L 31/18, H10K 30/00, H10K 85/00

(54) **PEROVSKITE-CRYSTALLINE SILICON TANDEM CELL COMPRISING CARRIER TRANSPORT LAYER HAVING NANO-RESISTANCE-INCREASING STRUCTURE**

(30) Priority: 18.11.2021 CN 202111370294
(71) Applicant: Longi Green Energy Technology Co., Ltd., Xi'an, Shaanxi 710100 (CN)
(72) Inventor: XIE, Junjie, Shaanxi 710100 (CN); XU, Chen, Shaanxi 710100 (CN); LI, Zifeng, Shaanxi 710100 (CN); DIAO, Yifan, Shaanxi 710100 (CN); WU, Zhao, Shaanxi 710100 (CN); SUN, Zhuxing, Shaanxi 710100 (CN)
(74) Representative: Grünecker Patent- und Rechtsanwälte PartG mbB
(86) International application number: PCT/CN2022/094410
(87) International publication number: WO 2023/087646

(57) **Abstract**

This application provides a perovskite-crystalline silicon tandem solar cell. The perovskite-crystalline silicon tandem solar cell includes a crystalline silicon solar cell, a serial connection structure layer, a first carrier transport layer, a perovskite light absorption layer, a second carrier transport layer, and an upper transparent electrode layer stacked in sequence, where the first carrier transport layer includes a carrier transport layer base layer and nano-resistance-increasing structures discretely distributed on the carrier transport layer base layer and integrally formed with the carrier transport layer base layer, and the nano-resistance-increasing structures extend from the carrier transport layer base layer into the perovskite light absorption layer. The perovskite-crystalline silicon tandem solar cell in this application can enhance a carrier collection and conduction capability of a carrier transport material, and can also greatly improve the energy conversion efficiency of the perovskite-crystalline silicon tandem solar cell. In addition, a light trapping effect of the perovskite-crystalline silicon tandem solar cell can be enhanced, and the conversion efficiency of the solar cell can be further improved; and perovskite composition may be adjusted flexibly, so that the energy conversion efficiency can be improved greatly.

## Description

### CROSS-REFERENCE TO RELATED APPLICATIONS

This application claims priority to Chinese Patent Application No. 202111370294.3 field with the China National Intellectual Administration Property on November 18, 2021 and entitled "PEROVSKITE-CRYSTALLINE SILICON TANDEM SOLAR CELL HAVING CARRIER TRANSPORT LAYER WITH NANO-RESISTANCE-INCREASING STRUCTURES", which is incorporated herein by reference in its entirety.

### TECHNICAL FIELD

This application relates to the field of solar cell technologies, and in particular, to a perovskite-crystalline silicon tandem solar cell having a carrier transport layer with nano-resistance-increasing structures.

### BACKGROUND

At present, highest energy conversion efficiency of a single-junction crystalline silicon solar cell is 26.7%, which is close to a theoretical upper limit of 29.4%, and there is little room for efficiency improvement. A perovskite solar cell is the most popular novel solar cell in the past decade, the efficiency of which has been improved from initial 3.8% to 25.5%, showing great application prospects. A theoretical upper limit of the efficiency of the perovskite solar cell is also about 30%, and there is also little room for efficiency improvement.

However, a perovskite-crystalline silicon tandem solar cell can be constructed based on a band gap difference between a perovskite material (about 1.4 eV to 1.8 eV) and a crystalline silicon material (1.14 eV), to obtain a solar cell with higher efficiency. Efficiency of the perovskite-crystalline silicon tandem solar cell can reach 40% or higher according to theoretical calculation, but at present, only 29.5% conversion efficiency is achieved in the laboratory, so there is still much room for efficiency improvement.

At present, the perovskite solar cell is mainly prepared through a solution method. The solution method has been used as a preparation method for a variety of high-efficiency perovskite solar cells due to its advantages such as low costs, simple preparation, and easy tuning of perovskite composition and band gap. However, during preparation of the perovskite-crystalline silicon tandem solar cell, a high-efficiency crystalline silicon solar cell has a textured light-trapping structure on its surface. It is difficult to obtain a perovskite absorption layer with a uniform thickness and high quality on the crystalline silicon textured surface by using the solution method.

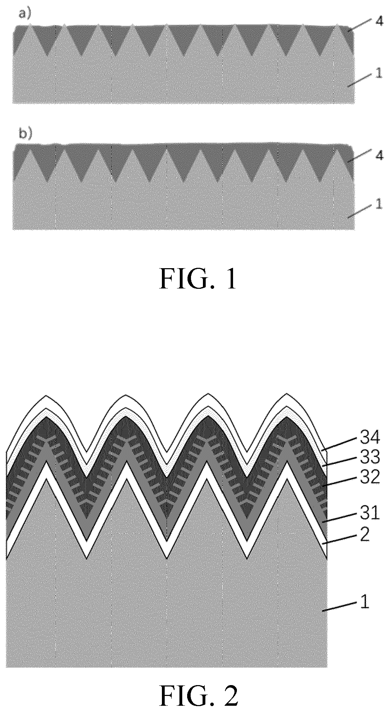

As shown in FIG. 1, 1 denotes a crystalline silicon solar cell and 4 denotes a perovskite thin film prepared through the solution method. When the perovskite thin film is prepared on the crystalline silicon textured surface by using the solution method, if a small amount of solution is added, the thin film is excessively thin, and tops of some pyramids on the textured surface cannot be covered by the perovskite thin film, resulting in a discontinuous thin film, which is likely to cause a short circuit of an upper-layer solar cell, as shown in FIG. 1a); and if the amount of solution applied is increased to ensure that tops of all pyramids are covered by the thin film, the perovskite thin film in bottom regions of the pyramids is excessively thick, as shown in FIG. 1b). An excessively thick absorption layer leads to an excessively long migration distance of photogenerated carriers, affecting efficiency of the solar cell.

In addition, at present, the size of pyramids on the textured surface of a commercial crystalline silicon solar cell generally ranges from 1 micrometer to 5 micrometers, the thickness of the absorption layer of a high-efficiency perovskite solar cell is generally not larger than 1 micrometer, and the excessively thick absorption layer leads to severe photogenerated carrier recombination, leading to a decrease in the efficiency of the solar cell. Therefore, even in the case shown in FIG. 1a) where the tops of some pyramids are not covered by the absorption layer, the thickness of the absorption layer in the bottom regions of most pyramids is larger than 1 micrometer, aggravating the carrier recombination. This is also an important factor that limits the efficiency improvement of the perovskite-crystalline silicon tandem solar cell.

Therefore, how to prepare a perovskite thin film with full coverage and a uniform and controllable thickness on a crystalline silicon solar cell having a textured surface by solution application to greatly improve the energy conversion efficiency of the perovskite-crystalline silicon tandem solar cell is a key technical problem to be resolved urgently.

### SUMMARY

For the problem existing in the related art, this application provides a perovskite-crystalline silicon tandem solar cell having a carrier transport layer with nano-resistance-increasing structures. Specifically, this application relates to the following aspects:
A perovskite-crystalline silicon tandem solar cell is provided, including a crystalline silicon solar cell, a serial connection structure layer, a first carrier transport layer, a perovskite light absorption layer, a second carrier transport layer, and an upper transparent electrode layer stacked in sequence, where the first carrier transport layer includes a carrier transport layer base layer and nano-resistance-increasing structures discretely distributed on the carrier transport layer base layer and integrally formed with the carrier transport layer base layer, and the nano-resistance-increasing structures extend from the carrier transport layer base layer into the perovskite light absorption layer.

Optionally, a surface of a side of the first carrier transport layer facing the perovskite light absorption layer has a textured surface.

Optionally, each of the nano-resistance-increasing structures is a fiber-like structure, a bar-shaped structure, or a nanotube structure.

Optionally, a length of each of the nano-resistance-increasing structures ranges from 50 nm to 1500 nm.

Optionally, a diameter of each of the nano-resistance-increasing structures ranges from 100 nm to 1000 nm.

Optionally, a coverage ratio of the nano-resistance-increasing structures on a surface of the carrier transport layer base layer ranges from 5% to 70%, and preferably ranges from 10% to 60%.

Optionally, a thickness of the carrier transport layer base layer ranges from 10 nm to 200 nm.

Optionally, the first carrier transport layer is selected from one of TiO₂, SnO₂, or ZnO or selected from one of PEDOT, PEDOT:PSS, P3HT, P3OHT, P3ODDT, PTAA, or NiO.

Optionally, the perovskite light absorption layer covers the first carrier transport layer and fills gaps of the nano-resistance-increasing structures of the first carrier transport layer.

Optionally, the serial connection structure layer is a conductive material layer or a tunnel junction layer.

This application further provides a method for preparing a foregoing perovskite-crystalline silicon tandem solar cell, including:
forming a serial connection structure layer on a surface of a crystalline silicon solar cell;
preparing a first carrier transport layer on a surface of the serial connection structure layer away from the crystalline silicon solar cell;
coating a perovskite light absorption layer on a surface of the first carrier transport layer away from the serial connection structure layer;
preparing a second carrier transport layer on a surface of the perovskite light absorption layer away from the first carrier transport layer; and
forming an upper transparent electrode layer on a surface of the second carrier transport layer away from the perovskite light absorption layer, where
the preparing of a first carrier transport layer includes preparing a carrier transport layer base layer and preparing nano-resistance-increasing structures to be discretely distributed and integrally formed with the carrier transport layer base layer on the carrier transport layer base layer.

Optionally, the preparing of the first carrier transport layer is through a one-step shape-preserving preparation method or a two-step shape-preserving preparation method.

Optionally, the preparing of the first carrier transport layer is through vapor deposition or electroplating.

This application provides a perovskite-crystalline silicon tandem solar cell, and the perovskite-crystalline silicon tandem solar cell has a carrier transport layer with nano-resistance-increasing structures. The carrier transport layer is used in an upper-layer solar cell of the perovskite-crystalline silicon tandem solar cell as a carrier transport layer, so that a carrier collection and conduction capability of a carrier transport material can be enhanced, and a perovskite precursor solution can further form a thin film with a uniform thickness and full coverage on pyramid structures on a textured surface of a crystalline silicon solar cell (based on a capillary effect of the nano structures). Therefore, thicknesses of perovskite thin films on tops and bottoms of the pyramids are basically consistent, and a problem that an absorption layer at the bottoms of the pyramids is excessively thick and vertexes of the pyramids cannot be fully covered is avoided, thereby greatly improving the energy conversion efficiency of the perovskite-crystalline silicon tandem solar cell. In addition, a light trapping effect of the perovskite-crystalline silicon tandem solar cell can be enhanced, and the conversion efficiency of the solar cell can be further improved; and perovskite composition may be adjusted flexibly, so that the energy conversion efficiency can be improved greatly.

The foregoing description is merely an overview of the technical solutions of this application. To understand the technical means of this application more clearly, implementation can be performed according to content of the specification. Moreover, to make the foregoing and other objectives, features, and advantages of this application more comprehensible, specific implementations of this application are particularly listed below.

### BRIEF DESCRIPTION OF THE DRAWINGS

To describe the technical solutions in the embodiments of this application or the related art more clearly, the accompanying drawings required for describing the embodiments or the related art are briefly described hereinafter. Apparently, the accompanying drawings in the following description show merely some embodiments of this application, and a person of ordinary skill in the art may obtain other accompanying drawings according to the accompanying drawings without creative efforts.

The accompanying drawings are provided for better understanding of this application and do not constitute an improper limitation to this application. In the accompanying drawings:
FIG. 1 is a schematic structural diagram of a perovskite-crystalline silicon tandem solar cell in the related art.
FIG. 2 is a schematic structural diagram of a perovskite-crystalline silicon tandem solar cell in this application.
FIG. 3 is a schematic diagram of applying a perovskite thin film on a surface of a carrier transport layer with (FIG. 3a)/without (FIG. 3b) nano-resistance-increasing structures by using a solution method.
FIG. 4 is a schematic structural diagram of nano-resistance-increasing structures in this application.

Descriptions of reference numerals:
1-crystalline silicon solar cell, 2-serial connection structure layer, 31-first carrier transport layer, 311-carrier transport layer base layer, 312-nano-resistance-increasing structure, 32-perovskite light absorption layer, 33-second carrier transport layer, 34-upper transparent electrode layer, and 4-perovskite thin film.

### DETAILED DESCRIPTION

To make the objectives, technical solutions, and advantages of the embodiments of this application clearer, the following clearly and completely describes the technical solutions in the embodiments of this application with reference to the accompanying drawings in the embodiments of this application. Apparently, the described embodiments are merely some embodiments of this application rather than all of the embodiments. Based on the embodiments in this application, all other embodiments obtained by a person of ordinary skill in the art without making creative efforts fall within the protection scope of this application.

Unless otherwise defined, meanings of all technical and scientific terms used in this specification are the same as those usually understood by a person skilled in the art. Although methods and materials similar to or the same as those described in this specification may be applied in experiments or actual applications, the materials and the methods are also described below in this specification. In case of conflict, this specification, including definitions, will control. In addition, the materials, methods, and examples are merely provided for description and are not limitative. This application is further described below with reference to specific embodiments, but the specific embodiments are not used to limit a scope of this application.

For the problem existing in the related art, this application provides a perovskite-crystalline silicon tandem solar cell having a carrier transport layer with nano-resistance-increasing structures. Specifically, a structure of the perovskite-crystalline silicon tandem solar cell is shown in FIG. 2 and includes a crystalline silicon solar cell 1, a serial connection structure layer 2, a first carrier transport layer 31, a perovskite light absorption layer 32, a second carrier transport layer 33, and an upper transparent electrode layer 34 stacked in sequence. The crystalline silicon solar cell 1 is a lower-layer solar cell, and the first carrier transport layer 31, the perovskite light absorption layer 32, the second carrier transport layer 33, and the upper transparent electrode layer 34 jointly form an upper-layer solar cell.

A type of the crystalline silicon solar cell 1 may be a monocrystalline silicon solar cell or a polysilicon solar cell, and a doping type of a silicon material of a substrate of the crystalline silicon solar cell is not limited. The doping type of the silicon material of the substrate may be a front PN junction structure or a back PN junction structure, or may be a single-surface or double-surface structure. The crystalline silicon solar cell 1 may be prepared by using a method known in the related art, or may be a commercialized crystalline silicon solar cell such as a P-PERC monocrystalline silicon solar cell, an HIT solar cell, or a Topcon solar cell.

In a specific implementation, a surface of the crystalline silicon solar cell 1 facing the serial connection structure layer 2 has a textured surface with pyramids. That is, the crystalline silicon solar cell 1 has the structure shown in FIG. 1, namely, the surface facing the serial connection structure layer 2 has a structure with pyramids arranged consecutively.

The serial connection structure layer 2 is located between the crystalline silicon solar cell 1 and the first carrier transport layer 31 and is configured to connect the upper-layer solar cell and the lower-layer solar cell in series. The serial connection structure layer 2 may be a conductive material layer, a tunnel junction layer, or may be another serial connection structure layer. A conductive material may be a transparent conductive semiconductor material such as indium tin oxide (ITO) or aluminum-doped zinc oxide (AZO), or may be a metal material or a mixed material of a plurality of metals. The conductive material layer may be a complete layer or may be a structure with holes or grooves in which the conductive material is filled.

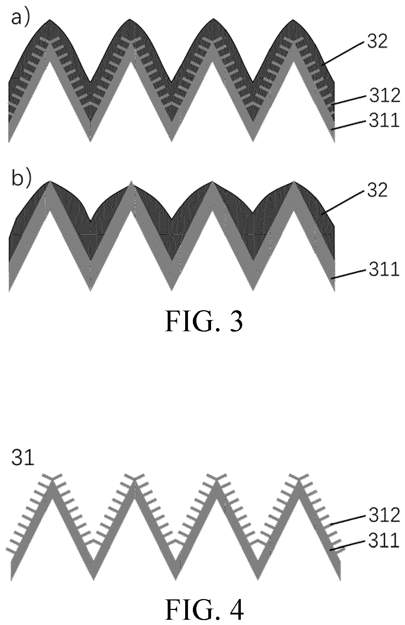

A structure of the first carrier transport layer 31 is shown in FIG. 2 and FIG. 4 and includes a carrier transport layer base layer 311 and nano-resistance-increasing structures 312 discretely distributed on the carrier transport layer base layer 311 and integrally formed with the carrier transport layer base layer, where the nano-resistance-increasing structures 312 extend from the carrier transport layer base layer 311 into the perovskite light absorption layer 32. Integral formation refers to that the carrier transport layer base layer 311 and the nano-resistance-increasing structures 312 are integrally formed and seamlessly connected, and the nano-resistance-increasing structures 312 are end structures of the carrier transport layer base layer 311.

The integral structure of the nano-resistance-increasing structures and the carrier transport layer base layer can reduce unnecessary interface resistance, and the nano-resistance-increasing structures extend into the perovskite light absorption layer as the end structures of the carrier transport layer base layer while fixing the perovskite light absorption layer, so that carrier transport can be further enhanced. In addition, the nano-resistance-increasing structures may further provide a light trapping function. Further, when the surface of the side of the first carrier transport layer facing the perovskite light absorption layer has the textured surface, the light trapping function can be further enhanced.

The first carrier transport layer 31 may be an organic polymer material or a metal oxide material. If the first carrier transport layer is the organic polymer material, the first carrier transport layer may be prepared through a one-step shape-preserving preparation method; and if the first carrier transport layer is the metal oxide material, the first carrier transport layer may be prepared through a two-step shape-preserving preparation method.

The first carrier transport layer 31 may be made of an electron transport material or may be made of a hole transport material. The electron transport material may be TiO₂, SnO₂, ZnO, poly(benzimidazobenzophenanthroline)-polyethyleneimine (BBL:PEI), or the like. The hole transport material may be PEDOT, PEDOT:PSS, P3HT, P3OHT, P3ODDT, PTAA, or NiO. The first carrier transport layer 31 with the nano-resistance-increasing structures 312 is used in the upper-layer solar cell of the perovskite-crystalline silicon tandem solar cell as a carrier transport layer, and a perovskite precursor solution can further form a thin film with a uniform thickness and full coverage on the pyramid structures on the textured surface of the crystalline silicon solar cell. A specific working principle of the nano-resistance-increasing structures 312 is shown in FIG. 3, where FIG. 3a is a schematic diagram of applying a perovskite thin film on a surface of a carrier transport layer with nano-resistance-increasing structures by using a solution method, and FIG. 3b is a schematic diagram of applying a perovskite thin film on a surface of a carrier transport layer without nano-resistance-increasing structures by using a solution method.

In FIG. 3a, after the nano-resistance-increasing structures 312 are arranged on the carrier transport layer base layer 311 and perovskite solution is applied on the textured surface with pyramids, namely, the crystalline silicon solar cell 1, due to a capillary effect of the nano structures, the perovskite precursor solution may be absorbed and fixed in the gaps among the nano structures, and a uniform coverage layer may be formed on a surface of the nano structures (due to tension of a liquid surface). After the solution is applied and before a perovskite light absorption layer thin film is obtained through heat treatment, a specific measure is adopted to remove excess solution in valley bottom regions of the textured surface with pyramids, and heat treatment is then performed on a wet film to obtain the perovskite light absorption layer 32 uniformly covering the carrier transport layer with the nano-resistance-increasing structures 312 shown in FIG. 3a, where the perovskite light absorption layer 32 can fully fill the gaps among the plurality of discretely distributed nano-resistance-increasing structures 312, thereby further enhancing a carrier collection and conduction capability of a carrier transport material.

As shown in FIG. 3b, when the nano-resistance-increasing structures 312 are not arranged, when the perovskite light absorption layer is prepared by using the solution method, a case shown in the figure may easily occur, namely, a large amount of solution is deposited in the valley bottom regions of the textured surface with pyramids, leading to an excessively thick perovskite light absorption layer; and the solution can be hardly adsorbed onto top regions of the pyramids, leading to an excessively thin absorption layer and even an exposed pyramid vertex.

Therefore, by using the nano-resistance-increasing structures 312 in this application, thicknesses of the perovskite on tops and bottoms of the pyramids are basically consistent, and a problem that an absorption layer at the bottoms of the pyramids is excessively thick and vertexes of the pyramids cannot be fully covered is avoided, thereby greatly improving the energy conversion efficiency of the perovskite-crystalline silicon tandem solar cell.

The carrier transport layer base layer 311 is arranged on a surface of the crystalline silicon solar cell 1, and a thickness of the carrier transport layer base layer may range from 10 nm to 200 nm. For example, the thickness of the carrier transport layer base layer may be 10 nm, 20 nm, 30 nm, 40 nm, 50 nm, 60 nm, 70 nm, 80 nm, 90 nm, 100 nm, 110 nm, 120 nm, 130 nm, 140 nm, 150 nm, 160 nm, 170 nm, 180 nm, 190 nm, or 200 nm. The carrier transport layer base layer 311 mainly plays a function of laterally collecting and transporting carriers, namely, laterally collecting and transporting carriers generated by the absorption layer to the serial connection structure layer. Therefore, the thickness of the carrier transport layer base layer should not be excessively large nor excessively small. If the base layer is excessively thick, a distance for longitudinally transporting the carriers to the serial connection structure layer is excessively long, leading to excessively large transport resistance; and if the base layer is excessively thin, a cross-sectional area of the thin film is excessively small, and lateral transport resistance is excessively large, which is not conducive to laterally collecting and transporting the carriers in the absorption layer.

As shown in FIG. 2 to FIG. 4, the nano-resistance-increasing structures 312 may be fiber-like structures, bar-shaped structures, or nanotube structures, so as to form a sawtooth or comb structure on the carrier transport layer base layer 311.

The nano-resistance-increasing structures 312 should not be excessively short nor excessively long. If the nano-resistance-increasing structures are excessively short, the capillary effect is too weak, and a resistance-increasing function is not obvious; and if the nano-resistance-increasing structures are excessively long, the absorption layer is excessively thick, which is not conducive to improving the efficiency of the upper-layer solar cell, and a difficulty in filling the perovskite precursor solution in roots of the nano structures is increased, leading to formation of some gaps in the roots and affecting the efficiency of the solar cell. Generally, in the perovskite-crystalline silicon tandem solar cell, a thickness of the absorption layer in the upper-layer perovskite solar cell is not larger than 1600 nm. Specifically, the thickness of the absorption layer of the upper-layer perovskite solar cell needs to be determined depending on a current of the lower-layer crystalline silicon solar cell according to a current matching principle. Therefore, it is proper that an upper limit of a length of each of the nano-resistance-increasing structures is not larger than the thickness of the absorption layer. Because when the length of each of the nano-resistance-increasing structures is larger than the thickness of the absorption layer of the upper-layer perovskite solar cell, the nano-resistance-increasing structures are in contact with an opposite carrier transport layer, leading to a short circuit and a decrease in the efficiency of the solar cell. Therefore, considering a thickness fluctuation of a part of the absorption layer exceeding each of the nano-resistance-increasing structures, the length of each of the nano-resistance-increasing structures in this application is less than or equal to 1500 nm.

In addition, when the absorption layer of the upper-layer perovskite solar cell is made of quantum dots, a size of each of the nano-resistance-increasing structures needs to be larger than a size of each of the quantum dots, otherwise the nano-resistance-increasing structures are negligible. Generally, the size of each of the quantum dots is less than 50 nm, so that the length of each of the nano-resistance-increasing structures in this application is larger than or equal to 50 nm.

In a specific implementation, the length of each of the nano-resistance-increasing structures 312 ranges from 50 nm to 1500 nm, and for example, may be 50 nm, 100 nm, 200 nm, 300 nm, 400 nm, 500 nm, 600 nm, 700 nm, 800 nm, 900 nm, 1000 nm, 1100 nm, 1200 nm, 1300 nm, 1400 nm, or 1500 nm. The length of each of the nano-resistance-increasing structures is a distance between a tail end of the nano-resistance-increasing structure to a surface of the carrier transport layer base layer facing the perovskite light absorption layer.

A diameter of each of the nano-resistance-increasing structures 312 needs to consider a resistance-increasing effect, a filling effect inside the nano-resistance-increasing structure, and a strength of the nano-resistance-increasing structure. In addition, the diameter of each of the nano-resistance-increasing structure further needs to consider a special size of each of the pyramid structures on the crystalline silicon textured surface. Generally, a size of each pyramid structure on the textured surface of an existing commercial crystalline silicon solar cell is larger than 1000 nm. Therefore, the diameter of each of the nano-resistance-increasing structures is generally not larger than 1000 nm. If the diameter is excessively large, the nano-resistance-increasing structures may fill the textured surface. As a result, "shape-preserving" cannot be achieved, and the light trapping effect of the textured surface cannot be kept. Meanwhile, if the diameter of each of the nano-resistance-increasing structures is excessively small, the strength of each nano-resistance-increasing structure is insufficient. As a result, the nano-resistance-increasing structure may be easily inclined or damaged, and the resistance-increasing effect cannot be achieved. In the field of nano materials, it is generally considered that a nano structure with a diameter larger than or equal to 100 nm has good performance in terms of strength and long-term stability.

In a specific implementation, the diameter of each of the nano-resistance-increasing structures 312 ranges from 100 nm to 1000 nm, and for example, may be 100 nm, 200 nm, 300 nm, 400 nm, 500 nm, 600 nm, 700 nm, 800 nm, 900 nm, or 1000 nm. The diameter of each nano-resistance-increasing structure is an average diameter of a cross section of the nano-resistance-increasing structure.

Considering an influence factor that the length of each of the nano-resistance-increasing structures 312 is the same as the diameter of each of the nano-resistance-increasing structures 312, a coverage ratio of the nano-resistance-increasing structures 312 on a surface of the carrier transport layer base layer 311 ranges from 5% to 70%, and preferably ranges from 10% to 60%. For example, the coverage ratio may be 5%, 10%, 20%, 30%, 40%, 50%, 60%, or 70%. The coverage ratio of the nano-resistance-increasing structures 312 on the surface of the carrier transport layer base layer 311 is a ratio of a total area of the nano-resistance-increasing structures 312 on the surface of the carrier transport layer base layer 311 to an area of the carrier transport layer base layer 311.

In addition to the advantage of greatly improving the energy conversion efficiency of the perovskite-crystalline silicon tandem solar cell, the perovskite-crystalline silicon tandem solar cell having a carrier transport layer with nano-resistance-increasing structures provided in this application further has the following technical effects:
(1) Because a perovskite thin film nearly shape-preserving grown is obtained on the crystalline silicon textured surface, a light-trapping structure of the crystalline silicon textured surface is kept in the upper-layer solar cell, so that the light trapping effect of the perovskite-crystalline silicon tandem solar cell can be enhanced, thereby further improving the conversion efficiency of the solar cell.
(2) Although a perovskite thin film with a uniform thickness and a shape-preserved morphology may be obtained through evaporation, during preparation of the perovskite thin film through evaporation, there is a large difficulty in tuning perovskite composition; and the difficulty in tuning the composition leads to a difficulty in tuning a band gap of the perovskite layer, which is not conducive to the absorption layer of the upper-layer solar cell of the tandem solar cell. By using the technical solution described in this application, the absorption layer of the upper-layer solar cell of the perovskite-crystalline silicon tandem solar cell may be grown in a shape-preserving manner with a band gap that can be flexibly adjusted, so that the energy conversion efficiency can be greatly improved.

This application further provides a preparation method for the foregoing perovskite-crystalline silicon tandem solar cell, including:
forming a serial connection structure layer on a surface of a crystalline silicon solar cell;
preparing a first carrier transport layer on a surface of the serial connection structure layer away from the crystalline silicon solar cell;
coating a perovskite light absorption layer on a surface of the first carrier transport layer away from the serial connection structure layer;
preparing a second carrier transport layer on a surface of the perovskite light absorption layer away from the first carrier transport layer; and
forming an upper transparent electrode layer on a surface of the second carrier transport layer away from the perovskite light absorption layer, where
the preparing a first carrier transport layer includes preparing a carrier transport layer base layer and preparing nano-resistance-increasing structures discretely distributed and integrally formed with the carrier transport layer base layer on the carrier transport layer base layer. The first carrier transport layer 31 cannot be prepared through a liquid application method. Because when the first carrier transport layer is prepared through the liquid application method, application on the pyramids on the textured surface is still uneven, which cannot completely resolve the technical problem in this application.

Therefore, a preparation method for the first carrier transport layer 31 needs to be featured by shape-preserving growing.

The "shape-preserving growing" means that after a coating or a thin film is prepared on a substrate with a specific surface morphology feature, the thin film grows along the original morphology of the substrate; and "a combination of the substrate and the thin film" with the coating or the thin film has the same "surface morphology feature" as that of an original surface of the substrate.

Specifically, the first carrier transport layer 31 may be prepared by using the following two methods:

### (1) One-step shape-preserving preparation method

A material for which the one-step shape-preserving preparation method may be used is an organic polymer material, and a vapor deposition method known in the field may be used.

The organic polymer first carrier transport layer with nano-resistance-increasing structures described in this patent may be synthesized in one step through the vapor deposition method.

Specifically, a substrate is prepared first, and a catalyst layer required for polymerization reaction of a polymer monomer is deposited on the substrate through physical vapor deposition. The substrate on which a catalyst is deposited is then placed in steam of the polymer monomer. The monomer steam encounters the catalyst on the substrate, and polymerization reaction occurs at a junction of interfaces of two phases.

A morphology control principle is: a, when steam pressure of the monomer in a reaction container is large, the monomer steam is condensed into droplets, when the droplets are in contact with the catalyst layer, reaction occurs in a contact region, and in a region not in contact with the droplets, no monomer exists and no polymerization reaction occurs, to form nano structures in this case; and b, when the steam pressure of the monomer in the reaction container is small, the monomer steam is uniformly distributed in a cavity of the reaction container, and the monomer is in uniform contact with the catalyst, to form a polymer thin film with a uniform and consistent thickness on the substrate.

In the foregoing polymerization reaction process, at the beginning of the process, the steam pressure of the monomer is controlled to be saturated to form the droplets so as to form the nano-resistance-increasing structures 312, and at a later stage of the process, the steam pressure is low, reaction occurs on the entire front surface to form the base layer 311 with a uniform and consistent thickness. Because the base layer 311 and the nano-resistance-increasing structures 312 are formed consecutively at one time, the base layer 311 and the nano-resistance-increasing structures 312 are integrally connected, which is more conducive to transport of carriers.

### (2) Two-step shape-preserving preparation method

A material for which the two-step shape-preserving preparation method may be used is a metal oxide material.

The first step needs to be featured by shape preserving (a necessary condition), and a physical vapor deposition method, an electroplating method, or the like may be used. One layer of a metal monomer thin film corresponding to "a metal oxide" is deposited or electroplated on a substrate.

In the second step, the metal monomer layer is oxidized into the metal oxide through anodic electrochemical oxidation.

A morphology control principle is: during anodic oxidation, parameters such as a current, a type of electrolyte solution, a solute concentration, and the like are controlled, when oxidation reaction occurs locally, the nano-resistance-increasing structures 312 are formed, and when the oxidation reaction occurs on the front surface, the base layer 311 is formed.

The foregoing metal oxidation process is not interrupted, and the nano-resistance-increasing structures 312 and the base layer 311 are integrally connected.

The perovskite light absorption layer 32 may be organic-hybrid halide perovskite, all-inorganic halide perovskite, or may be a light absorption material of another perovskite structure such as lead-free perovskite or double perovskite.

The second carrier transport layer 33 may be made of an electron transport material or a hole transport material, but has a conductive type opposite to a conductive type of the first carrier transport layer 31. That is, when the first carrier transport layer 31 is made of the electron transport material, the second carrier transport layer 33 is made of the hole transport material; and when the first carrier transport layer 31 is made of the hole transport material, the second carrier transport layer 33 is made of the electron transport material.

The upper transparent electrode layer 34 may be a transparent electrode commonly used in the related art, and for example, may be FTO, ITO, or AZO.

### Embodiments

### Embodiment 1

A heterojunction (HJT) solar cell using an N-type silicon wafer is provided as a lower-layer solar cell.

A serial connection structure layer is prepared on a surface of the HJT solar cell using an N-type silicon wafer through magnetron sputtering, where the serial connection structure layer uses ITO and has a thickness of 200 nm.

A first carrier transport layer is prepared on a surface of the serial connection structure layer, where the first carrier transport layer is a hole transport layer with nano-resistance-increasing structures and uses PEDOT synthesized through vapor deposition, a thickness of a carrier transport layer base layer is 50 nm, each of the nano-resistance-increasing structures is fiber-like and has a length of 500 nm and a diameter of 150 nm, and a coverage ratio of the nano-resistance-increasing structures on a surface of the carrier transport layer base layer is 40%. A form, the length, and the diameter of each of the nano-resistance-increasing structures may be observed through an electron microscope, and the coverage ratio on the surface may be obtained through a specific surface area analyzer.

A perovskite light absorption layer is coated on a surface of the first carrier transport layer away from the serial connection structure layer, where the perovskite light absorption layer uses MAPbI3 perovskite and has a thickness of 800 nm. The perovskite is coated through dip coating, where a crystalline silicon solar cell covered by the first carrier transport layer is immersed in 1.5 M MAPbI3 perovskite solution in DMF, and the crystalline silicon solar cell covered by the first carrier transport layer is withdrawn at a speed of 20 mm/min. After withdrawal is ended, the crystalline silicon solar cell covered by the first carrier transport layer is dried for 10 minutes at 100°C, to obtain the MAPbI3 perovskite light absorption layer.

A second carrier transport layer is prepared on a surface of the perovskite light absorption layer away from the first carrier transport layer through evaporation, where the second carrier transport layer is an electron transport layer, uses C60 as a material of the electron transport layer, and has a thickness of 50 nm.

An upper transparent electrode layer is formed on a surface of the second carrier transport layer away from the perovskite light absorption layer through magnetron sputtering, where the upper transparent electrode layer uses ITO and has a thickness of 300 nm.

The first carrier transport layer is synthesized through vapor deposition, and specific steps are as follows: a 20 nm-thick ferric oxide layer is deposited on a substrate through physical deposition, 12 µL of concentrated hydrochloric acid and 60 µL of 1.56 M pyrrole solution in chlorobenzene are added to a glass reactor and reacted with the ferric oxide layer for 1.5 h at 130°C, to finally obtain a PEDOT thin film and PEDOT comb structures containing the impurity FeCl₂, and a PEDOT hole transport layer with nano-resistance-increasing structures is finally obtained after being rinsed with 6 M HCl.

The efficiency of the perovskite-PERC crystalline silicon tandem solar cell in this embodiment is 28.1%.

### Embodiment 2

A heterojunction (HJT) solar cell using an N-type silicon wafer is provided as a lower-layer solar cell.

A serial connection structure layer is prepared on a surface of the HJT solar cell using an N-type silicon wafer through magnetron sputtering, where the serial connection structure layer uses ITO and has a thickness of 200 nm. A first carrier transport layer is prepared on a surface of the serial connection structure layer, where the first carrier transport layer is an electron transport layer with nano-resistance-increasing structures and uses a TiO₂ array prepared through anodic oxidation, a thickness of a carrier transport layer base layer is 20 nm, each of the nano-resistance-increasing structures is bar-shaped and has a length of 400 nm and a diameter of 150 nm, and a coverage ratio of the nano-resistance-increasing structures on the carrier transport layer base layer is 60%.

A perovskite light absorption layer is coated on a surface of the first carrier transport layer away from the serial connection structure layer, where the perovskite light absorption layer uses a FAPbI3 perovskite material and has a thickness of 700 nm. The perovskite is coated through dip coating, where a crystalline silicon solar cell covered by the first carrier transport layer is immersed in 1.3 M FAPbI3 perovskite (a solvent is a mixed solvent in which DMF:DMSO=4:1) solution, and the crystalline silicon solar cell covered by the first carrier transport layer is withdrawn at a speed of 25 mm/min. After withdrawal is ended, the crystalline silicon solar cell covered by the first carrier transport layer is dried for 15 minutes at 120°C, to obtain the FAPbI3 perovskite light absorption layer.

A second carrier transport layer is prepared on a surface of the perovskite light absorption layer away from the first carrier transport layer, where the second carrier transport layer is a hole transport layer, uses Spiro-TTB, has a thickness of 100 nm, and is prepared through evaporation.

An upper transparent electrode layer is formed on a surface of the second carrier transport layer away from the perovskite light absorption layer, where the upper transparent electrode layer uses ITO, has a thickness of 350 nm, and is prepared through magnetron sputtering (in the related art).

The first carrier transport layer is prepared through anodic oxidation, and specific steps are as follows: a 100 nm-thick Ti thin film is evaporated on a substrate through evaporation, the substrate on which the Ti thin film is evaporated is used as an anode and a Pt sheet is used as a cathode, and the substrate is placed in electrolyte of 0.5 wt% NH₄F aqueous solution (PH=4 to 5) for oxidation for 4 hours at a voltage of 18 V, to obtain a TiO₂ electro transport layer with nano-resistance-increasing structures.

The efficiency of the perovskite-HJT crystalline silicon tandem solar cell in this embodiment is 27.6%.

### Embodiment 3

A difference between this embodiment and Embodiment 1 lies in that the length of each of the nano-resistance-increasing structures in this embodiment is 300 nm.

The efficiency of the tandem solar cell obtained in this embodiment is 26.8%.

### Embodiment 4

A difference between this embodiment and Embodiment 1 lies in that the coverage ratio of the nano-resistance-increasing structures in this embodiment is 5%.

The efficiency of the tandem solar cell obtained in this embodiment is 25.1%.

### Embodiment 5

A difference between this embodiment and Embodiment 1 lies in that the coverage ratio of the nano-resistance-increasing structures in this embodiment is 70%.

The efficiency of the tandem solar cell obtained in this embodiment is 24.9%.

### Embodiment 6

A difference between this embodiment and Embodiment 1 lies in that the length of each of the nano-resistance-increasing structures in this embodiment is 50 nm.

The efficiency of the tandem solar cell obtained in this embodiment is 27.5%.

### Embodiment 7

A difference between this embodiment and Embodiment 1 lies in that the length of each of the nano-resistance-increasing structures in this embodiment is 1100 nm.

The efficiency of the tandem solar cell obtained in this embodiment is 26.9%.

### Comparative embodiment 1

A difference between this embodiment and Embodiment 1 lies in that the first carrier transport layer in this embodiment merely includes the base layer and does not include the nano-resistance-increasing structures.

The efficiency of the tandem solar cell obtained in this embodiment is 24.1%.

### Comparative embodiment 2

A heterojunction (HJT) solar cell using an N-type silicon wafer is provided as a lower-layer solar cell.

A serial connection structure layer is prepared on a surface of the HJT solar cell using an N-type silicon wafer through magnetron sputtering, where the serial connection structure layer uses ITO and has a thickness of 200 nm. A 50 nm-thick dense SnO₂ thin film is prepared on the serial connection structure layer through magnetron sputtering as a first carrier transport layer, where a top surface of the lower-layer solar cell, the serial connection structure layer, and the first carrier transport layer all have a textured surface with quasi-pyramids; and TiO₂ nano-resistance-increasing materials are prepared on a surface of the first carrier transport layer having the textured surface with quasi-pyramids.

Specifically, preparation is performed by using the following method: 1) A suspension containing TiO₂ suspended nanoparticles is formulated, where a size of each of the TiO₂ nanoparticles ranges from 10 nm to 150 nm. A ratio of a volume of the TiO₂ suspended particles to a total volume of the suspension is 1:1000. 2) A TiO₂ suspension with a thickness of 2000 nm is uniformly coated on a surface of the first carrier transport layer having the textured surface with quasi-pyramids through a brush with a wedge-shaped end. 3) The first carrier transport layer is placed and dried quickly at 200°C to remove moisture, to obtain TiO₂ nano-resistance-increasing materials with an average gap of 100 nm on the first carrier transport layer. A coverage ratio of the TiO₂ nano-resistance-increasing materials on the first carrier transport layer is 40%. 4) The textured surface with quasi-pyramids having dispersed nanoparticles is placed at a high temperature of 500°C for annealing for 10 min, so that the bonding strength between the TiO₂ nanoparticles and the first carrier transport layer is improved, and a first carrier transport layer with protruding TiO₂ nano-resistance-increasing materials at the nano level on a surface is obtained.

A perovskite light absorption layer is coated on the surface of the first carrier transport layer covered by the TiO2 nano-resistance-increasing materials, where the perovskite light absorption layer uses a FAPbI3 perovskite material and has a thickness of 700 nm. The perovskite is coated through dip coating, where a crystalline silicon solar cell covered by the first carrier transport layer is immersed in 1.3 M FAPbI3 perovskite (a solvent is a mixed solvent in which DMF:DMSO=4:1) solution, and the crystalline silicon solar cell covered by the first carrier transport layer is withdrawn at a speed of 25 mm/min. After withdrawal is ended, the crystalline silicon solar cell covered by the first carrier transport layer is dried for 15 minutes at 120°C, to obtain the FAPbI3 perovskite light absorption layer.

A second carrier transport layer is prepared on a surface of the perovskite light absorption layer away from the first carrier transport layer, where the second carrier transport layer is a hole transport layer, uses Spiro-TTB, has a thickness of 100 nm, and is prepared through evaporation.

An upper transparent electrode layer is formed on a surface of the second carrier transport layer away from the perovskite light absorption layer, where the upper transparent electrode layer uses ITO, has a thickness of 350 nm, and is prepared through magnetron sputtering (in the related art).

The first carrier transport layer 31 is prepared through anodic oxidation, and specific steps are as follows: a 100 nm-thick Ti thin film is evaporated on a substrate through evaporation, the substrate on which the Ti thin film is evaporated is used as an anode and a Pt sheet is used as a cathode, and the substrate is placed in electrolyte of 0.5 wt% NH₄F aqueous solution (PH=4 to 5) for oxidation for 4 hours at a voltage of 18 V, to obtain a TiO₂ electro transport layer with nano-resistance-increasing structures.

The efficiency of the perovskite-HJT crystalline silicon tandem solar cell in this embodiment is 24.8%.

Specific conditions of the foregoing embodiments and comparative embodiments are shown in Table 1.

**Table 1**

| | Preparation method for nano-resistance-increasing structure | Shape of nano-resistance-increasing structure | Length (nm) of nano-resistance-increasing structure | Diameter (nm) of nano-resistance-increasing structure | Coverage ratio of nano-resistance-increasing structure | Efficiency of tandem solar cell |
|---|---|---|---|---|---|---|
| Embodiment 1 | Vapor deposition | Fiber-like | 500 | 150 | 40% | 28.1% |
| Embodiment 2 | Anodic oxidation | Bar-shaped | 400 | 150 | 60% | 27.6% |
| Embodiment 3 | Vapor deposition | Fiber-like | 300 | 150 | 40% | 26.8% |
| Embodiment 4 | Vapor deposition | Fiber-like | 500 | 150 | 5% | 25.1% |
| Embodiment 5 | Vapor deposition | Fiber-like | 500 | 150 | 70% | 24.9% |
| Embodiment 6 | Vapor deposition | Fiber-like | 50 | 150 | 40% | 27.5% |
| Embodiment 7 | Vapor deposition | Fiber-like | 1500 | 150 | 40% | 26.9% |
| Comparative embodiment 1 | - | - | - | - | - | 24.1% |
| Comparative embodiment 2 | Coating | Particle | - | 10-150 | 40% | 24.8% |

By comparing Embodiments 1, 4, and 5 in this application, it may be learned that for the nano-resistance-increasing structures in this application, when the coverage ratio of the nano-resistance-increasing structures on the first carrier transport layer is 5%, compared with a case that the coverage ratio is 40%, an efficiency gain is low. Because the nano-resistance-increasing structures are very sparse, the resistance-increasing effect is limited, the improvement of the carrier absorption and conduction performance is small, and the efficiency improvement is limited. Therefore, the coverage ratio of the nano-resistance-increasing structures should not be smaller than 5%. When the coverage ratio of the nano-resistance-increasing structures on the first carrier transport layer is 70%, compared with the case that the coverage ratio is 40%, an efficiency gain is low. Because the coverage ratio is excessively large, leading to excessively large roughness of the first carrier transport layer, which is not conducive to formation of a high-quality perovskite absorption layer thin film. However, the quality of the absorption layer thin film is vital to the efficiency of the solar cell. Therefore, when the coverage ratio continues to be increased, the efficiency of the solar cell is sharply decreased, so that the coverage ratio of the nano-resistance-increasing structures should not be larger than 70%

It may be learned by testing and comparing the efficiency of the tandem solar cells in Embodiments 1 to 7 in this application and Comparative Embodiments 1 and 2 that, compared with a tandem solar cell without nano-resistance-increasing materials or a tandem solar cell with nano-resistance-increasing materials formed through a conventional manner, the efficiency of the solar cell in the technical solutions of this application is significantly improved. Although TiO₂ nano-resistance-increasing materials are used in Comparative Embodiment 2, the first carrier transport layer and the TiO₂ nano-resistance-increasing materials are different conductive materials and are merely in contact with each other through a physical interface, so that large contact resistance is generated on the contact interface. In a case that the coverage ratio of the TiO₂ nano-resistance-increasing materials on the surface of the first carrier transport layer reaches 40%, the contact resistance leads to a carrier transport obstacle between the first carrier transport layer and the perovskite light absorption layer; and the TiO₂ nano-resistance-increasing materials are distributed between the first carrier transport layer and the perovskite light absorption layer, a few carrier recombination centers may be formed, leading to a significant decrease in the conversion efficiency of the solar cell.

Although the implementations of this application is described above, this application is not limited to the foregoing specific implementations and application fields, and the foregoing specific implementations are merely exemplary and instructive rather than limitative. A person of ordinary skill in the art may further make, under the teaching of this specification, various forms without departing from the protection scope of the claims of this application, and all the forms fall within the protection scope of this application.

## Claims

1. A perovskite-crystalline silicon tandem solar cell, comprising a crystalline silicon solar cell, a serial connection structure layer, a first carrier transport layer, a perovskite light absorption layer, a second carrier transport layer, and an upper transparent electrode layer stacked in sequence, wherein the first carrier transport layer comprises a carrier transport layer base layer and nano-resistance-increasing structures discretely distributed on the carrier transport layer base layer and integrally formed with the carrier transport layer base layer, and the nano-resistance-increasing structures extend from the carrier transport layer base layer into the perovskite light absorption layer.

2. The perovskite-crystalline silicon tandem solar cell according to claim 1, wherein a surface of a side of the first carrier transport layer facing the perovskite light absorption layer has a textured surface.

3. The perovskite-crystalline silicon tandem solar cell according to claim 1, wherein each of the nano-resistance-increasing structures is a fiber-like structure, a bar-shaped structure, or a nanotube structure.

4. The perovskite-crystalline silicon tandem solar cell according to claim 3, wherein a length of each of the nano-resistance-increasing structures ranges from 50 nm to 1500 nm.

5. The perovskite-crystalline silicon tandem solar cell according to claim 4, wherein a diameter of each of the nano-resistance-increasing structures ranges from 100 nm to 1000 nm.

6. The perovskite-crystalline silicon tandem solar cell according any one of to claim 1 to 5, wherein a coverage ratio of the nano-resistance-increasing structures on a surface of the carrier transport layer base layer ranges from 5% to 70%, and preferably ranges from 10% to 60%.

7. The perovskite-crystalline silicon tandem solar cell according to claim 1, wherein a thickness of the carrier transport layer base layer ranges from 10 nm to 200 nm.

8. The perovskite-crystalline silicon tandem solar cell according to claim 1, wherein the first carrier transport layer is selected from one of TiO₂, SnO₂, or ZnO or selected from one of PEDOT, PEDOT:PSS, P3HT, P3OHT, P3ODDT, PTAA, or NiO: A flux is coated on a surface of a conductive boss.

9. The perovskite-crystalline silicon tandem solar cell according to claim 1, wherein the perovskite light absorption layer covers the first carrier transport layer and fills gaps of the nano-resistance-increasing structures of the first carrier transport layer.

10. The perovskite-crystalline silicon tandem solar cell according to claim 1, wherein the serial connection structure layer is a conductive material layer or a tunnel junction layer.

11. A method for preparing a perovskite-crystalline silicon tandem solar cell according to any one of claim 1 to 10, comprising:
forming a serial connection structure layer on a surface of a crystalline silicon solar cell;
preparing a first carrier transport layer on a surface of the serial connection structure layer away from the crystalline silicon solar cell;
coating a perovskite light absorption layer on a surface of the first carrier transport layer away from the serial connection structure layer;
preparing a second carrier transport layer on a surface of the perovskite light absorption layer away from the first carrier transport layer; and
forming an upper transparent electrode layer on a surface of the second carrier transport layer away from the perovskite light absorption layer, wherein
the preparing of a first carrier transport layer comprises preparing a carrier transport layer base layer and preparing nano-resistance-increasing structures to be discretely distributed and integrally formed with the carrier transport layer base layer on the carrier transport layer base layer.

12. The preparation method according to claim 11, wherein the preparing of the first carrier transport layer is through a one-step shape-preserving preparation method or a two-step shape-preserving preparation method.

13. The preparation method according to claim 11, wherein the preparing of the first carrier transport layer is through vapor deposition or electroplating.
